# FASCICULE DE BREVET EUROPEEN

(11) **EP 0 682 406 B1**
(45) Date de publication et mention de la délivrance du brevet: **30.09.1998**
(21) Numéro de dépôt: 95401066.6
(22) Date de dépôt: 09.05.1995
(51) Int. Cl.: H03F 1/32

(54) **Linéarisateur à prédistorsion large bande et auto compensé en température pour amplificateur hyperfréquence**
Linearisierer mit Breitbandvorverzerrung und Temperaturselbstkompensierung für Mikrowellenverstärker
Lineariser with broadband predistortion and temperature self-compensation for microwave amplifier

(30) Priorité: 11.05.1994 FR 9405821
(43) Date de publication de la demande: 15.11.1995
(73) Titulaire: ALCATEL ALSTHOM COMPAGNIE GENERALE D'ELECTRICITE, 75008 Paris (FR)
(72) Inventeur: Pouysegur, Michel, F-31410 Noe (FR); Nicolas, François, F-31650 st Orens de Gameville (FR)
(74) Mandataire: Pothet, Jean Rémy Emile Ludovic

(56) Documents cités:
- EP-A- 0 040 127
- US-A- 5 291 148

## Description

L'invention concerne le domaine de télécommunications par ondes électromagnétiques, et plus particulièrement des dispositifs d'amplification hyperfréquence utilisés dans des équipements d'émission et/ou de réception dans de tels systèmes de télécommunications. Plus précisément, l'invention concerne un linéariseur à prédistorsion pour amplificateur hyperfréquence, destiné à pallier des effets de non-linéarité induits par les différentes conditions d'amplification rencontrées dans les divers régimes de fonctionnement de l'équipement.

L'utilisation d'un linéariseur est rendue nécessaire par le fait bien connu de l'homme de l'art, que si, pour obtenir un bon rendement électrique d'un amplificateur, en particulier d'un amplificateur de puissance, celui-ci doit fonctionner près de la saturation. Or, près de ce point de fonctionnement, la linéarité de l'amplificateur est fortement dégradée par rapport à la linéarité de ce même amplificateur utilisé avec des signaux d'amplitude plus faibles que ceux nécessaires pour amener celui-ci en régime de saturation.

Afin d'accroître la dynamique en régime linéaire d'un amplificateur, sans sacrifier le rendement électrique obtenu près de la saturation, il est connu d'utiliser un dispositif de correction de non-linéarités, que l'on appelle un linéariseur. Ils sont classiquement de trois types : soit à boucle de rétroaction négative ("feed back" en anglais), soit en boucle ouverte ("feed foward"), soit du type dite linéariseur à prédistorsion.

Le linéariseur en configuration "feed back" convient à des amplificateurs travaillant à des fréquences relativement basses, et dont les variations des caractéristiques des signaux et donc de la linéarité de l'amplificateur, sont plus lentes que le temps de réaction de la boucle, c'est-à-dire entre la détection d'une non-linéarité et la correction de celle-ci. En revanche, cette configuration est très difficile à mettre en oeuvre pour l'amplification de signaux hyperfréquence, car trop lente par rapport aux fréquences du signal pour donner des résultats satisfaisants.

En hyperfréquence, on préfère alors l'utilisation soit d'un linéariseur à boucle ouverte, soit d'un linéariseur à prédistorsion. Le principe repose sur l'extraction via un coupleur, d'une partie du signal avant l'amplification de celui-ci, qui est ensuite traité par différent composants électroniques actifs et passifs pour obtenir un signal non-linéaire de correction, ayant les mêmes caractéristiques de non-linéarité que celles du signal utile à corriger, mais en opposition de phase. Dans un circuit linéariseur à boucle ouverte, l'addition du signal de correction ainsi obtenu avec le signal utile amplifié, permet d'obtenir la linéarité recherchée. Le linéariseur à prédistorsion, en revanche, fourni un signal de correction avec le signal à amplifier à l'entrée de l'amplificateur hyperfréquence de puissance dont on voudrait corriger les non-linéarités.

Différents types de linéariseurs à prédistorsion ont déjà été étudiés. Une première famille de linéariseurs à prédistorsion est décrite par exemple par le document US-A-4.992.754 de BLAUVELT et al., au nom de ORTEL Corp. (USA). Selon l'enseignement de ce document, le signal utile est appliqué à une ligne à retard, tandis que le signal de correction est élaboré dans une branche parallèle, avec un réglage d'amplitude pour le rendre égal à celui de la non-linéarité du signal amplifié, et un réglage de la phase du signal pour obtenir une opposition de phase par rapport au signal utile qui se propage sur la ligne à retard. Le signal utile et le signal de correction sont additionnés à l'aide d'un combineur ou d'un coupleur hyperfréquence, et ensuite acheminés sur l'entrée de l'amplificateur hyperfréquence de puissance. Les non-linéarités constatées à la sortie de l'étage d'amplification de puissance sont ainsi sensiblement diminuées sinon éliminées. On peut citer aussi un autre type de linéariseur à prédistorsion connu par exemple par le document US-A-4.068.186 de SATO et al., au nom de KDD (Japon). Ce linéariseur, montré schématiquement sur la figure 1, est conçu pour travailler à des hautes fréquences pour pallier les non-linéarités d'un amplificateur du type TOP (tube à ondes progressives) ou klystron. Comme générateur de non-linéarité, SATO et al. enseigne l'utilisation d'un TOP de faible puissance. Ce genre d'amplificateur introduit un léger retard (du à la vitesse finie de propagation d'électrons dans le vide) du signal amplifié par rapport au signal non amplifié. Afin de synchroniser les signaux des voies non-linéaire et linéaire, il faut donc introduire une ligne à retard 3 dans la branche correctrice.

Le signal à amplifier est présenté à l'entrée 1 du linéariseur de SATO et al., d'où il est appliqué à un premier correcteur de caractéristique amplitude-fréquence 10. La sortie dudit premier correcteur 10 est ensuite fourni à un coupleur diviseur 2 qui divise le signal en deux parties, pour les appliquer respectivement aux entrées de deux lignes de transmission, la première comprenant une ligne à retard 3, et la deuxième comprenant un amplificateur hyperfréquence 4 générateur d'une distorsion non-linéaire, par exemple un TOP faible puissance. La quatrième branche du coupleur 2 est terminée par une charge adaptée 8. Classiquement, le coupleur diviseur 2 introduit un décalage de phase θ entre les deux signaux fournis en sortie. Ce coupleur peut être par exemple un coupleur hybride 3dB, ce qui introduit un déphasage de θ= π/2=90°.

La voie principale (dite la voie linéaire) comprend donc un amplificateur hyperfréquence 4 dont le point de fonctionnement est choisi près de la saturation pour obtenir la génération de non-linéarités qui dépendent de la puissance du signal d'entrée. Afin de pouvoir régler le niveau de sortie du dispositif linéariseur à prédistorsion, sans agir sur le gain de l'amplificateur 4, un atténuateur variable 13 est situé en sortie de l'amplificateur 4.

L'autre voie de SATO et al. (dite la voie non-linéaire) comprend, outre la ligne à retard 3, un correcteur 9 de la caractéristique phase-fréquence. Les signaux des deux voies sont appliqués aux deux entrées d'un deuxième coupleur combineur 5, ou ils sont additionnés (encore avec un décalage de phase θ entre les deux signaux). Ce coupleur peut être par exemple un coupleur hybride 3dB, ce qui introduit encore un déphasage de θ = π/2. La quatrième branche du coupleur 5 est terminée par une charge adaptée 7. Le signal résultant de l'addition des deux signaux présents sur les deux entrées est ensuite fourni à un deuxième correcteur de caractéristique amplitude-fréquence 12. Enfin le signal utile, imprimé avec une prédistorsion, est fourni à la sortie 6 du dispositif où il sera appliqué à l'entrée d'un amplificateur hyperfréquence de puissance.

Ce dispositif de l'art antérieur comprend donc deux organes correcteurs 12,10 de la caractéristique non-linéaire amplitude-fréquence, ainsi qu'un organe correcteur 9 de la caractéristique phase-fréquence. Des exemples de réalisation de tels organes correcteurs sont décrits dans le document SATO et al., dont le texte de la description est expressément incorporé par référence dans la présente demande, pour ce qui concerne sa description de réalisations de l'art antérieur.

Les caractéristiques non linéaires de ces organes s'ajoutent à ceux de l'amplificateur hyperfréquence 4. Les fonctions de transfert de tous ces organes varient de façon disparate en fonction de la fréquence et de l'amplitude des signaux, ou encore en fonction de la température des composants. On s'arrange pour que le signal non-linéaire ainsi élaboré soit additionné au signal utile en opposition de phase, pour annuler les non linéarités de l'amplificateur hyperfréquence de puissance (non montré), mais uniquement dans une bande de fréquence relativement étroite et dans une gamme de puissance d'entrée relativement réduite, et à une température donnée.

En jouant sur les caractéristiques des organes correcteurs 9,10,12 on peut obtenir une fonction de transfert dont le gain et la phase augmentent avec le niveau du signal d'entrée. Ceci est généralement la réponse recherchée lorsque l'on souhaite linéariser un TOP de puissance.

Un autre réglage des organes correcteurs 9, 10, 12 permet d'obtenir une fonction de transfert dont le gain augmente avec le niveau du signal d'entrée mais dont la phase diminue avec celui-ci. Il s'agit dans ce cas de la réponse recherchée lorsque l'on souhaite linéariser un amplificateur de puissance à l'état solide.

Un autre linéariseur hyperfréquence large bande est décrit dans l'article de A.M. KHILLA, "Novel Broadband Linearizers and their application in power amplifiers for satellite transponders and ground stations", Paru dans Proceedings Second European Conference on Satellite Communications, Liege, Belgium, 22-24 October 1991 pp 229-234, publié par ESA (L'agence Spatiale Européenne), publication no. SP-332, article qui fait partie intégrante de la présente demande pour sa description de l'art antérieur.

Ce document enseigne l'utilisation d'un circuit de prédistorsion afin de linéariser un amplificateur large bande de transpondeur spatial en bande Ku. Comme dans le document de SATO et al., le circuit aurait deux branches, connectées à leurs extrémités par deux coupleurs 3dB hybride, chacun introduisant un déphasage de 90°. Il enseigne en outre l'utilisation de longueurs électriques équivalentes dans les deux branches, une configuration assez rare dans les autres circuits de prédistorsion décrits par ailleurs dans la littérature.

Le principe des linéariseurs à prédistorsion illustré par les documents de l'art antérieur cités ci-dessus convient pour les applications hyperfréquences. Il présente cependant plusieurs inconvénients majeurs qui rendent sa mise en oeuvre difficile. On peut en citer parmi d'autres :
- un premier inconvénient réside dans le fait que les opérations de réglage initial des circuits correcteurs (10,12) de la caractéristique amplitude-fréquence et du correcteur (9) de la caractéristique phase-fréquence, sont souvent longues et délicates à réaliser, tâche compliquée d'avantage dans le cas habituel ou les longueurs électriques des deux voies sont généralement très différentes ;
- un deuxième inconvénient provient du fait que les deux voies étant constituées d'éléments différents, leurs comportements en fonction de la température sont différents également. Il en résulte des variations des caractéristiques des organes correcteurs et donc de la fonction de transfert globale du dispositif, ces variations étant particulièrement sensibles à la température ;
- un autre inconvénient des dispositifs de l'art antérieur est que la largeur de bande de fonctionnement optimal du dispositif correcteur de non-linéarités est en fait limitée par les différences ou par des variations différentielles des longueurs électriques des deux voies, soit en fonction de la fréquence ou de l'amplitude des signaux à amplifier, soit en fonction des conditions de fonctionnement dont notamment la température.

L'invention a pour but de pallier les inconvénients de l'art antérieur.

L'art antérieur US-A-5 291 148 propose un linéariseur à prédistorsion pour amplificateur hyperfréquence, ledit linéariseur comprenant en outre :
- un diviseur d'entrée 22 comportant une entrée et deux sorties, ayant un déphasage relatif de 90° entre les deux sorties ;
- une première voie dite linéaire et une deuxième voie dite non-linéaire, lesdites voies linéaire et non-linéaire présentant sensiblement la même longueur électrique ; et
- un combineur de sortie 15 ayant deux entrées et une sortie, ayant un déphasage relatif de 90° entre les deux entrées ;
tel que ladite première voie et ladite deuxième voie sont constituées par des circuits de même nature et de même schéma électrique mais utilisant des diodes PIN dans une voie et des diodes Schottky dans l'autre : les circuits ne sont donc pas identiques.

Selon la présente invention, ladite première voie et ladite deuxième voie sont constituées par des circuits identiques. Selon une caractéristique, ledit diviseur 22 est un coupleur hybride 3 dB. Selon une autre caractéristique, ledit combineur 15 est un coupleur hybride 3 dB. Selon une variante, ledit diviseur 22 est un coupleur à lignes couplées. Selon une autre variante, ledit combineur 15 est un coupleur à anneau.

L'invention propose en outre différentes technologies de réalisation des circuits du linéariseur, qui peut être réalisé au moins en partie en technologie MMIC. Selon une variante, ledit linéariseur est réalisé au moins en partie en technologie MIC. Enfin, l'invention propose également un amplificateur hyperfréquence comportant un linéariseur selon l'une quelconque des variantes précédentes.

L'invention sera mieux comprise, et ses différentes caractéristiques et avantages ressortiront de la description détaillée qui suit d'un exemple de réalisation, et de ses figures annexées, dont :
- la figure 1, déjà décrite, montre un linéariseur à prédistorsion de l'art antérieur ; et
- la figure 2, montre schématiquement un exemple d'une réalisation d'un linéariseur à prédistorsion selon l'invention.

Les figures sont données à titre d'exemples non limitatifs pour illustrer les principales caractéristiques de l'invention et de ses variantes. Les mêmes repères se réfèrent aux mêmes éléments sur les deux figures. Des moyens équivalents peuvent être substitués aux éléments représentés sur les figures sans sortir pour autant du cadre de l'invention.

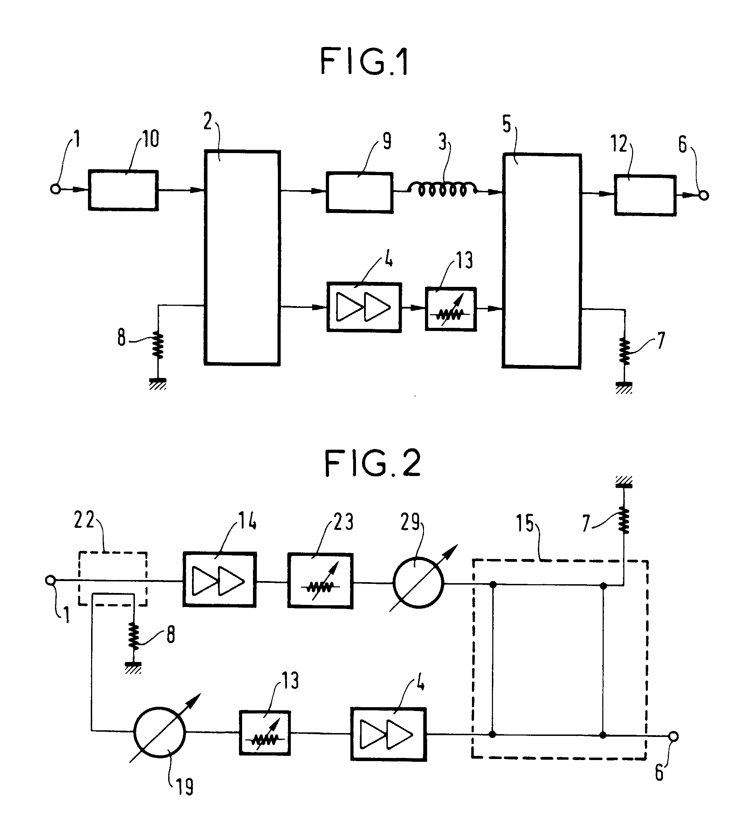

La figure 2 montre un exemple d'un linéariseur selon l'invention. Le schéma ressemble en plusieurs points au schéma de la figure 1 qui représente l'art antérieur. Comme dans la figure précédente, le signal à amplifier est présenté à l'entrée 1 du linéariseur, d'où il est appliqué à l'entrée d'un coupleur diviseur de puissance 22, dont l'une des branches est terminée sur une charge adaptée 8. Le signal est ainsi divisé en deux parties, qui sont appliquées respectivement aux entrées de deux lignes de transmission. Classiquement, le coupleur diviseur 22 introduit un décalage de phase θ entre les deux signaux fournis en sortie vers les deux lignes de transmission. Ce coupleur 22 peut être par exemple un coupleur hybride 3dB, ce qui introduit un déphasage de θ = π/2 (= 90°). Dans une réalisation préférée de l'invention, ce coupleur 22 peut aussi bien être un coupleur à lignes couplées, réalisé en technologie microruban par exemple.

La première ligne de transmission (dite la voie non-linéaire) comprend un amplificateur 14, générateur d'une distorsion non linéaire d'amplitude de même nature que celle de l'amplificateur de puissance que l'on voudrait linéariser, un atténuateur variable 13, et un déphaseur variable 29.

Sur la deuxième ligne de transmission (dite la voie linéaire), nous avons également un déphaseur variable 19, un atténuateur variable 13 et un amplificateur hyperfréquence 4.

Les signaux sur les deux voies sont ensuite additionnés par un coupleur combineur 15, dont l'une des branches est terminée sur une charge adaptée 7. Le signal de correction par prédistorsion est fourni en sortie 6 du coupleur combineur 15 à un amplificateur hyperfréquence de puissance (non montré). Classiquement, le coupleur combineur 15 introduit un décalage de phase θ entre les deux signaux fournis sur ses entrées par les deux lignes de transmission, avant leur sommation. Ce coupleur 15 peut être par exemple un coupleur hybride 3dB, ce qui introduit un déphasage de θ = π/2 (= 90°). Dans une réalisation préférée de l'invention, ce coupleur 15 peut aussi bien être un coupleur à anneau, également capable d'introduire le déphasage voulu.

En plus des éléments essentiels de l'invention énuméres ci-dessus, d'autres éléments peuvent être introduits sur chaque voie, à condition que les longueurs électriques des éléments introduits sur chaque voie soient identiques, d'une part, et que leurs éventuelles variations de caractéristiques (fonctions de transfert) en fonction notamment de la température ou du régime de fonctionnement (fréquence, puissance du signal d'entrée), soient les mêmes d'autre part.

Aussi, dans une réalisation préférée de l'invention, chaque voie comprend en outre un atténuateur fixe (non-montrés explicitement sur la figure 2). Ces atténuateurs fixes peuvent avoir des valeurs d'atténuation différentes mais leurs longueurs électriques seront identiques. De cette manière, les longueurs électriques de tous les circuits sur chaque voie étant identiques, le dispositif linéariseur de l'invention fonctionne correctement dans une très large bande de fréquences, car la fonction de transfert de chaque voie varie de la même façon en fonction de la fréquence.

La construction exposée ci-dessus à l'aide de la figure 2 présente donc un déphasage naturel de 180° entre les deux voies, ce déphasage total résultant uniquement des déphasages introduits par les deux coupleurs diviseur 22 et combineur 15. Puisque les circuits se trouvant sur les deux voies sont identiques, et que les réglages des circuits identiques seront approximativement les mêmes sur les deux voies, les variations éventuelles de fonctions de transfert en fonction de la température générée sur les deux voies sont additionnées en opposition de phase et s'annulent. Le dispositif selon l'invention est ainsi autocompensé en température.

Puisque les longueurs électriques des deux voies sont identiques, la fonction de transfert du dispositif selon l'invention est indépendante de la fréquence, il fonctionne correctement sur une très large bande de fréquence.

En outre, comme il est bien connu de l'homme de l'art, le déphasage relatif Δφ des signaux sur la voie linéaire et la voie non-linéaire pour obtenir une fonction de transfert globale du linéariseur correspondant à un TOP comme amplificateur hyperfréquence de puissance, est toujours de l'ordre de Δφ ≈ - 170°, avec une différence d'amplitude ΔV sur les deux voies de l'ordre de 3dB. Pour un amplificateur hyperfréquence de puissance à l'état solide, en revanche, le déphasage relatif des signaux sur les deux voies est de l'ordre de Δφ ≈ + 170°. On constate que dans les deux cas, le déphasage naturel de 180° entre les deux voies donne un pré réglage du linéariseur selon l'invention, qui permet : d'une part, d'économiser le temps consacré aux réglages fins des déphaseurs variables du linéariseur ; et d'autre part, d'assurer que les deux déphaseurs réglables auront des valeurs semblables, donc un point de fonctionnement voisin, obtenu par des polarisations des composants qui seront pratiquement les mêmes. Ceci permet de garder des longueurs électriques identiques dans les deux voies.

Dans une réalisation préférée de l'invention, des atténuateurs fixes sont ajoutés dans chaque voie. Il convient, pour les applications précitée de linéarisation d'un amplificateur hyperfréquence de puissance à l'état solide ou d'un TOP, de prévoir une valeur d'atténuation de l'atténuateur fixe dans la voie non linéaire supérieur de 3 dB à la valeur d'atténuation de l'atténuateur fixe de la voie linéaire. De cette manière, s'il reste des petits réglages d'amplitude à faire dans l'une ou l'autre des deux voies, ceci peut être effectué sans modification sensible du point de fonctionnement et donc sans modification sensible des longueurs électriques des deux voies.

Dans cette réalisation, on voit que les deux voies sont naturellement réglées très proche du point optimum, défini par : Δφ ≈ ± 170°, ΔV ≈ 3dB. L'ajustage final de la différence de phase ou de la différence de l'amplitude des signaux qui se propagent dans les deux voies linéaire et non linéaire, est alors réalisé à l'aide des circuits atténuateurs ou déphaseurs situés dans chaque des deux voies. Le fait que le réglage naturel des amplitudes et des phases des signaux se propageant dans les deux voies est très proche du réglage optimum, entraîne que les conditions de polarisation des circuits de réglage fin (atténuateurs et déphaseurs) seront similaires. Leurs fonctions de transfert resteront quasi identiques, du fait que tout réglage à faire sera forcement petit à partir du réglage naturel Δφ ≈ 180°, Δ V ≈ 3dB.

Des essais ont été effectués pour vérifier l'efficacité et le bon fonctionnement du dispositif selon l'invention. Le linéariseur décrit a été associé à un TOP pour lequel l'expansion requise du gain à saturation de celui-ci est de 4 dB et l'expansion de phase égale à 40°. Nous avons pu constater d'une part que le linéariseur était naturellement proche du réglage souhaité et que l'ajustement fin de ce réglage a pu être réalisé très rapidement. Nous avons pu constater également que le linéariseur selon l'invention fonctionne parfaitement dans une large bande de fréquence sans modification de réglage aucune. Sa bande passante en bande C est supérieure à 20 % , pour une première maquette de réalisation.

Enfin, dans une gamme de température variant de -10°C à +60°C, la variation de la courbe d'expansion du gain du linéariseur s'est avérée négligeable et la variation de la courbe d'expansion de phase très faible puisque inférieure à 5° à saturation.

Les circuits qui constituent les deux voies du dispositif de linéariseur selon l'invention peuvent être réalisés selon les techniques habituelles de l'homme du métier, et en particulier par les technologies MMIC ou MIC. Les circuits peuvent être réalisés collectivement ou individuellement, et ensuite reliés par des circuits microruban, ou par des techniques hybrides. Le dispositif de l'invention se prête naturellement à une réalisation par les techniques de MMIC, dans la mesure où les circuits dans chaque voie doivent être identiques, et donc sont facilement reproduits à partir d'une bibliothèque de composants MMIC standards.

Enfin, le dispositif linéariseur selon l'invention est destiné à faire partie d'un amplificateur hyperfréquence de puissance, dont il améliore la linéarité dans une large bande de fréquence, et dans des conditions de fonctionnement variables. L'invention propose donc un amplificateur hyperfréquence comprenant un linéariseur tel que décrit ci-dessus.

Pour résumer les avantages de l'invention, le dispositif de linéarisation à prédistorsion proposé est constitué de deux voies linéaire et non linéaire constituées des mêmes éléments pour lesquels les conditions de polarisations et les points de fonctionnement sont identiques ou quasi identiques. Il en résulte que la fonction de transfert globale du dispositif n'est pas ou très peu affectée par la variation de température de celui-ci. Le dispositif selon l'invention peut être ainsi caractérisé comme auto compensé en température.

De plus, de par le fait que les longueurs électriques des voies soient identiques ou quasi identiques, ce dispositif fonctionne dans une très large bande de fréquence.

D'autre part, l'utilisation originale d'un coupleur à lignes couplées en entrée et d'un coupleur en anneau en sortie associée avec le fait que les deux voies sont réalisées à l'aide des mêmes éléments fait que le dispositif selon l'invention présente un réglage naturel des phases (et dans une réalisation particulière, des amplitudes), correspondant à une application pour amplificateur à TOP ou à l'état solide. Le dispositif de l'invention est donc pré réglé.

Bien entendu, l'invention n'est pas limitée aux exemples discutés et décrits ci-dessus, mais peut s'appliquer dans les limites fixées par les revendications à toutes les réalisations utilisant un ou plusieurs moyen(s) équivalent(s) au moyens décrits à titre d'exemple, pour remplir les mêmes fonctions, en vu d'obtenir les mêmes résultats.

## Revendications

1. Linéariseur à prédistorsion pour amplificateur hyperfréquence, ledit linéariseur comprenant en outre :
- un diviseur d'entrée 22 comportant une entrée et deux sorties, ayant un déphasage relatif de 90° entre les deux sorties ;
- une première voie dite linéaire et une deuxième voie dite non-linéaire, lesdites voies linéaire et non-linéaire présentant sensiblement la même longueur électrique ; et
- un combineur de sortie 15 ayant deux entrées et une sortie, ayant un déphasage relatif de 90° entre les deux entrées ;
**caractérisé en ce que** ladite première voie et ladite deuxième voie sont constituées par des circuits identiques.

2. Linéariseur selon la revendication 1, caractérisé en ce que ledit diviseur 22 est un coupleur hybride 3 dB.

3. Linéariseur selon la revendication 1, caractérisé en ce que ledit combineur 15 est un coupleur hybride 3 dB.

4. Linéariseur selon la revendication 1, caractérisé en ce que ledit diviseur 22 est un coupleur à lignes couplées.

5. Linéariseur selon la revendication 1, caractérisé en ce que ledit combineur 15 est un coupleur à anneau.

6. Linéariseur selon l'une quelconque des revendications précédentes, caractérisé en ce qu'il est réalisé au moins en partie en technologie MMIC.

7. Linéariseur selon l'une quelconque des revendications précédentes, caractérisé en ce qu'il est réalisé au moins en partie en technologie MIC.

8. Amplificateur hyperfréquence comportant un linéariseur selon l'une quelconque des revendications précédentes.

## Patentansprüche

1. Linearisierer mit Vorverzerrung für einen Ultrahochfrequenzverstärker, wobei der Linearisierer außerdem umfaßt:
- einen Eingangsteiler 22, der einen Eingang und zwei Ausgänge aufweist, der eine relativen Phasenverschiebung von 90° zwischen den beiden Ausgängen hat,
- einen ersten Weg, linear genannt, und einen zweiten Weg, nichtlinear genannt, wobei die linearen und nichtlinearen Wege im wesentlichen die gleiche elektrische Länge haben, und
- einen Ausgangskombinierer 15 mit zwei Eingängen und einem Ausgang, der eine relative Phasenverschiebung von 90° zwischen den beiden Eingängen hat,
dadurch gekennzeichnet, daß der erste Weg und der zweite Weg aus gleichen Schaltungen bestehen.

2. Linearisierer nach Anspruch 1, dadurch gekennzeichnet, daß der Teiler 22 ein 3-dB-Hybridrichtungskoppler ist.

3. Linearisierer nach Anspruch 1, dadurch gekennzeichnet, daß der Kombinierer 15 ein 3-dB-Hybridrichtungskoppler ist.

4. Linearisierer nach Anspruch 1, dadurch gekennzeichnet, daß der Teiler 22 ein Koppler mit gekoppelten Leitungen ist.

5. Linearisierer nach Anspruch 1, dadurch gekennzeichnet, daß der Kombinierer 15 ein Ringkoppler ist.

6. dadurch gekennzeichnet, daß er wenigstens teilweise in MMIC-Technologie ausgeführt ist.

7. Linearisierer nach einem der vorhergehenden Ansprüche, dadurch gekennzeichnet, daß er wenigstens teilweise in MIC-Technologie ausgeführt ist.

8. Ultrahochfrequenzverstärker, der einen Linearisierer nach einem der vorhergehenden Ansprüche aufweist.

## Claims

1. Predistortion lineariser for microwave amplifiers, said lineariser further including:
- an input power divider 22 having one input and two outputs with a relative phase-shift of 90° between the two outputs;
- a linear first channel and a non-linear second channel, said linear and non-linear channels having substantially the same electrical length; and
- an output power combiner 15 having two inputs and one output with a relative phase-shift of 90° between the two inputs;
characterised in that said first channel and said second channel comprise identical components.

2. Lineariser according to claim 1 characterised in that said power divider 22 is a 3 dB hybrid coupler.

3. Lineariser according to claim 1 characterised in that said power combiner 15 is a 3 dB hybrid coupler.

4. Lineariser according to claim 1 characterised in that said power divider 22 is a branch-line coupler.

5. Lineariser according to claim 1 characterised in that said power combiner 15 is a ring coupler.

6. Lineariser according to any one of the preceding claims characterised in that at least part of it is implemented in MMIC technology.

7. Lineariser according to any one of the preceding claims characterised in that at least part of it is implemented in MIC technology.

8. Microwave amplifier including a lineariser according to any one of the preceding claims.
